# EUROPÄISCHE PATENTSCHRIFT

(11) **EP 2 154 728 B1**
(45) Veröffentlichungstag und Bekanntmachung des Hinweises auf die Patenterteilung: **17.02.2016**
(21) Anmeldenummer: 09075356.7
(22) Anmeldetag: 10.08.2009
(51) Int. Cl.: H01L 31/048

(54) **Verfahren zur Herstellung von mechanisch vorgespannten Solarzellenverbunden sowie mechanisch vorgespanntes Solarzellenmodul**
Method for producing mechanically pre-stressed solar cell laminates and mechanically pre-stressed solar cell module
Procédé de fabrication de stratifiés de cellules solaires mécaniquement prétendues et module de cellules solaires mécaniquement prétendues

(30) Priorität: 14.08.2008 DE 102008037821
(43) Veröffentlichungstag der Anmeldung: 17.02.2010
(73) Patentinhaber: Fraunhofer-Gesellschaft zur Förderung der angewandten Forschung e.V., 80686 München (DE)
(72) Erfinder: Wirth, Harry, Dr., 79249 Merzhausen (DE)

(56) Entgegenhaltungen:
- DE-A1- 4 222 806
- DE-A1-102006 048 216
- US-A- 4 331 494
- US-A- 4 578 526
- US-A- 5 667 595
- US-A1- 2006 207 646

## Beschreibung

Die vorliegende Erfindung betrifft ein Verfahren zur Herstellung eines Solarzellenverbundes, der eine auf einem Substrat aufgebrachte und/oder von einem Superstrat überschichtete Solarzelle aufweist, wobei das Substrat und/oder das Superstrat über eine Fixierung mit der Solarzelle verbunden wird. Das Substrat und/oder Superstrat weist dabei einen höheren thermischen Ausdehnungskoeffizienten als die Solarzelle auf, wobei beim Herstellungsverfahren vor der Fixierung der Solarzelle auf dem Substrat und/oder dem Superstrat höhere Prozesstemperaturen angewandt werden. Nach Aushärtung der Fixierung und Abkühlung auf Raumtemperatur steht die Solarzelle unter vom Substrat und/oder Superstrat ausgehenden und durch die Fixierung auf die Solarzelle übertragenden tangentialen Druck, der dem gesamten Solarzellenverbund eine deutlich erhöhte Stabilität verleiht.

Solarzellen werden überwiegend auf Silicium-Wafern gefertigt, die als spröd-brechendes Material eine sehr geringe Festigkeit gegen Zuglasten zeigen. Die Festigkeit gegen Drucklasten ist hingegen deutlich höher.

Solarzellen auf Wafer-Basis müssen daher zum Schutz gegen äußere Einflüsse eingekapselt werden. Als äußere Schicht wird i.A. Glas eingesetzt. Bei sehr dünnen Zellen (< 150 µm) führen gängige Schichtaufbauten zu kritischen Zugbelastungen der Zellen.

Nach dem Stand der Technik werden wafer-basierte Solarzellen in Verkapselungsmassen von beidseitig ca. 500 µm Dicke eingebettet. Als Materialien werden Elastomere oder Thermoplaste eingesetzt, um die Spannungen aufgrund unterschiedlicher thermischer Ausdehnungskoeffizienten und aufgrund einer Moduldurchbiegung zu verringern. Diese Materialien weisen hierfür eine visko-elastische Verformbarkeit auf (z.B. EP 1 225 642).

DE10 2006 048 216 A1 offenbart ein Herstellungsverfahren eines Solarzellenmoduls und ein dadurch herstellbares Solarzellenmodul, wobei eine Solarzelle mittels einer thermoplastischen Siloxancopolymerfolie auf einem Glassubstrat mit linearem Wärmeausdehnungskoeffizienten von ca. 9.10⁻⁶/ °K fixiert wird.

Während bei dieser Technologie bei Zelldicken bis ca. 150 µm und gängigen Lastszenarien die Solarzellen nicht bis zur Versagensgrenze belastet werden, wird es bei Zelldicken unter 150 µm kritisch. Diese dünnen Zellen kommen aber verstärkt auf den Markt.

Aufgabe der vorliegenden Erfindung war es somit, ein Verfahren zur Herstellung eines Solarzellenmoduls bereitzustellen, über das Solarzellenmodule mit hoher mechanischer Stabilität zugänglich sind. Ebenso war es Aufgabe der vorliegenden Erfindung, entsprechende Solarzellenmodule anzugeben.

Diese Aufgabe wird bezüglich des Verfahrens mit den Merkmalen des Patentanspruchs 1 sowie bezüglich des Solarzellenmoduls mit den Merkmalen des Patentanspruchs 9 gelöst. Die jeweiligen abhängigen Ansprüche stellen dabei vorteilhafte Weiterbildungen dar.

Erfindungsgemäß wird somit ein Verfahren zur Herstellung eines Solarzellenmoduls angegeben, das folgende Schritte umfasst:
a) Zumindest bereichsweises Aufbringen eines Precursormaterials auf mindestens eine der Kontaktflächen einer Solarzelle, eine Oberfläche eines Substrats und/oder eines Superstrats,
b) Zusammenfügen der Kontaktflächen,
c) Erwärmen des Substrats, des Superstrats, der Solarzelle und/oder des Precursormaterials auf eine Verarbeitungstemperatur von mindestens 100 °C
d) Aushärtung des Precursormaterials zur Fixierung der Solarzelle mit dem Substrat und/oder dem Superstrat, sowie
e) Abkühlen des Verbundes auf Umgebungstemperatur,
wobei der thermische Ausdehnungskoeffizient vom Substrat und/oder Superstrat größer als der thermische Ausdehnungskoeffizient der Solarzelle ist und wobei der Wärmeausdehnungskoeffizient des Substrats und/oder des Superstrats mindestens 5.10⁻⁶/°C bei 20°C beträgt, so dass die Solarzelle bleibend oder dauerhaft für die Lebensdauer des Solarzellenmoduls unter einem vom Substrat und/oder Superstrat ausgehenden und über die Fixierung auf die Solarzelle übertragendem tangentialem Druck steht. Die Schritte a), b) und c) können dabei auch in umgekehrter Reihenfolge ausgeführt werden. Maßgeblich ist, dass das Precursormaterial noch nicht zur Fixierung ausgehärtet ist, wenn die einzel- nen Bauteile zusammen gefügt werden.

Das Precursormaterial ist ausgewählt aus der Gruppe bestehend aus bei der Verarbeitungstemperatur durch Vernetzung aushärtbaren organischen Materialien und/oder glasartigen anorganischen Materialien, wobei die aushärtbaren organischen Materialien ausgewählt sind aus der Gruppe bestehend aus Monomeren, Oligomeren und/oder Präpolymeren von Duroplasten.

Erfindungsgemäß ist somit vorgesehen, dass je nach Ausführung des erfindungsgemäßen Verfahrens auf mindestens eine Kontaktfläche (d.h. mindestens eine Oberfläche der jeweiligen Solarzelle, die mit dem Substrat bzw. Superstrat zusammen gefügt werden soll) ein härtbares Precursormaterial aufgebracht wird. Zusätzlich oder alternativ hierzu ist es jedoch auch möglich, das härtbare Precursormaterial auf die Oberfläche des Substrates bzw. des Superstrates aufzubringen. Als Precursormaterialien kommen dabei alle beispielsweise chemisch oder thermisch aushärtbaren und somit einen dauerhaften Verbund zwischen Solarzelle und Substrat bzw. Superstrat bildenden Materialien in Frage.

Im nächsten Schritt des Verfahrens erfolgt ein Zusammenfügen der mit dem Precursormaterial benetzten Flächen der Solarzelle und des Substrates und/oder des Superstrates.

In einem weiteren Schritt, der auch vor dem Zusammenfügen oder auch gleichzeitig hierzu durchgeführt werden kann, erfolgt ein Erwärmen zumindest des Substrates und/oder des Superstrates, gegebenenfalls auch der Solarzelle, wodurch gewährleistet ist, dass aufgrund des höheren thermischen Ausdehnungskoeffizienten des Substrates bzw. des Superstrates eine größere absolute Ausdehnung des Substrates bzw. des Superstrates erfolgt. Nach z.B. thermischer Aushärtung des Precursormaterials wird der entstandene Verbund auf Umgebungstemperatur abgekühlt, wobei gewährleistet ist, dass die durch die thermische Kontraktion beim Abkühlen auftretenden Kräfte vom Substrat und/oder Superstrat durch die Fixierung auf die So-larzelle übertragen werden. Die Solarzelle steht somit unter permanentem tangentialem Druck, der durch die größere absolute thermisch bedingte Größenänderung des Substrates bzw. Superstrates, verglichen mit der Größenänderung der Solarzelle ausgeht.

Die Erfindung kann somit vorteilhaft zur Herstellung von wafer-basierten PV-Modulen mit besonders dünnen Zellen (< 150 µm) eingesetzt werden.

Die Erfindung ermöglicht den Einsatz von sehr dünnen Zellen (< 150 µm) und die damit verbundenen Kosteneinsparungen auf Zellseite. Weiterhin kann die Dicke des Fixiermaterials von derzeit ca. 500 µm deutlich reduziert werden (beispielsweise auf 50 µm). Damit sinkt die Betriebstemperatur der Module und steigt ihr Ertrag.

Ein weiterer Vorteil kommt zum Tragen, wenn Module über ein beschleunigtes Verfahren nur randseitig, beispielsweise mit dem Material TPS, und nicht mehr massiv eingekapselt werden. Die erfindungsgemäße Fixierung der Solarzellen sorgt dann bereits für eine Sicherung der Zellen im gasgefüllten (Scheiben-)Zwischenraum.

Das mindestens eine Precursormaterial ist ausgewählt aus der Gruppe bestehend aus bei der Verarbeitungstemperatur durch Vernetzung aushärtbaren organischen Materialien und/oder glasartigen anorganischen Materialien, insbesondere Glaslot.

Die aushärtbaren organischen Materialien sind aus der Gruppe bestehend aus Monomeren, Oligomeren und/oder Präpolymeren von Duroplasten, insbesondere Epoxidharzen, Phenol-Harzen, (Meth)acrylharzen und/oder Polyurethanharzen, ausgewählt.

In einer weiter vorteilhaften Ausführungsform werden als Substrat und/oder Superstrat Glasmaterialien mit einem linearen Wärmeausdehnungskoeffizienten α von mindestens 6·10⁻⁶/K bei 20 °C, besonders bevorzugt mindestens 7·10⁻⁶/K bei 20 °C eingesetzt.

Vorteilhaft ist ebenso, wenn als Solarzelle eine scheibenförmige Solarzelle eingesetzt wird.

Bevorzugte Dicken der Solarzelle liegen dabei bei < 500 µm, bevorzugt < 300 µm, besonders bevorzugt < 150 um.

Vorteilhaft ist ebenso, wenn das die Fixierung bildende mindestens eine Precursormaterial in einer Dicke von 5 bis 500 µm, bevorzugt von 10 bis 100 µm, besonders bevorzugt von 20 bis 50 µm aufbracht wird.

Bevorzugte Verarbeitungstemperaturen reichen dabei von 100 bis 600 °C, bevorzugt von 100 bis 300 °C, besonders bevorzugt von 150 bis 250 °C.

Erfindungsgemäß wird ebenso ein Solarzellenmodul nach einem Verfahren wie in den Ansprüchen 1-8 angegeben bereitgestellt, umfassend mindestens eine über eine Fixierung zumindest bereichsweise kraft- und formschlüssig mit mindestens einem Substrat und/oder Superstrat verbundene Solarzelle, wobei der thermische Ausdehnungskoeffizient vom Substrat und/oder Superstrat größer als der thermische Ausdehnungskoeffizient der Solarzelle ist und die Solarzelle in einem Temperaturbereich unterhalb 100 °C unter einem vom Substrat und/oder Superstrat ausgehenden und über die Fixierung auf die Solarzelle übertragenen tangentialem Druck steht.

Insbesondere weist das erfindungsgemäß bereitgestellte Solarzellenmodul eine Fixierung mit einer Schichtdicke von 5 bis 500 µm, bevorzugt von 10 bis 100 µm, besonders bevorzugt von 20 bis 50 µm auf.

Weiter bevorzugt ist es, wenn das Solarzellenmodul eine rückseitig auf die Solarzelle und/oder das Superstrat aufgebrachte Verkapselung, auf der eine Rückseitenfolie, eine Glasplatte und/oder eine Metallschicht oder -folie oder -platte, bevorzugt eine Rückseitenfolie aus einen Fluorpolymer, angeordnet ist, aufweist.

In einer alternativen bevorzugten Ausführungsform weist das Modul eine rückseitig auf die Solarzelle und/oder das Superstrat aufgebrachte Rückseitenfolie, eine Glasplatte und/oder eine Metallschicht, -folie oder -platte auf, die lediglich im Randbereich über eine umlaufende Abdichtung mit dem Superstrat und/oder der Solarzelle verbunden ist. Dabei ergibt sich zwischen der Abdichtung, dem Substrat bzw. der Solarzelle und der rückseitigen Abdeckung ein gasgefüllter Raum, dessen Dicke der Schichtdicke der Fixierung entspricht. Dieser Gasraum kann mit beliebigen Gasen gefüllt sein.

Zur besseren Verständlichkeit der Ausführung der vorliegenden Erfindung wird der erfindungsgemäße Gegenstand nachstehend anhand eines Ausführungsbeispiels sowie einer Figur näher erläutert.

Die Fixierung wird durch ein Material erreicht, das hohe Festigkeit ohne nennenswerte visko-elastische Eigenschaften aufweist, beispielsweise Duromere, Polymere unterhalb der Glasübergangstemperatur oder glasartige anorganische Materialien.

Dieses Fixiermaterial ist derartig beschaffen, dass es bei erhöhten Temperaturen (beispielsweise > 100 °C, bevorzugt > 150 °C) von Glas und Solarzelle, beispielsweise durch Vernetzung, aushärtet. Beim Auskühlen des geschaffenen Verbundes wird die Solarzelle aufgrund des höheren thermischen Ausdehnungskoeffizienten von Glas unter tangentialen Druck gesetzt. Wegen der starren Verbindung zum Glas bleibt eine Druckreserve für die Lebensdauer des Moduls erhalten.

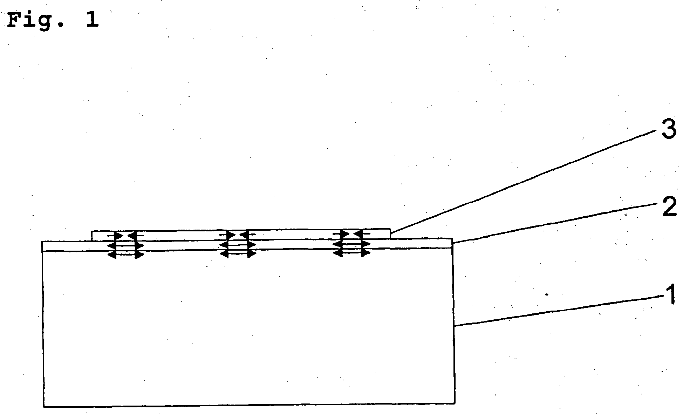

Figur 1 zeigt den Schichtaufbau mit Glas(Superstrat) 1, Fixiermaterial 2 und Zelle 3. Die Zelle steht unter Gebrauchsbedingungen des Moduls überwiegend unter tangentialem Druck (zusammenführende Pfeile), Fixiermaterial und Glas stehen unter Zug (auseinanderstrebende Pfeile).

Beim Auskühlen auf Gebrauchstemperatur wird der Verbund zur Wölbung neigen. Diese Wölbung kann durch eine Ausführung der rückseitigen Abdeckung mit erhöhtem E-Modul oder durch konstruktive Aufnahme der Kräfte bei der Modulmontage auf das erforderliche Maß reduziert werden.

Die Erfindung eignet sich besonders für Zellen mit Rückkontakten, die eine im Wesentlichen flache Vorderseite aufweisen.

## Patentansprüche

1. Verfahren zur Herstellung eines Solarzellen moduls mit folgenden Schritten:
a) Zumindest bereichsweises Aufbringen eines Precursormaterials auf mindestens eine der Kontaktflächen einer Solarzelle (3), eine Oberfläche eines Substrats und/oder eines Superstrats (1),
b) Zusammenfügen der Kontaktflächen,
c) Erwärmen des Substrats, des Superstrats (1), der Solarzelle (3) und/oder des Precursormaterials auf eine Verarbeitungstemperatur von mindestens 100 °C, wobei die Schritte a), b) und c) auch in beliebiger Reihenfolge ausgeführt werden können,
d) Aushärtung des Precursormaterials zur Fixierung (2) der Solarzelle (3) mit dem Substrat und/oder dem Superstrat, sowie
e) Abkühlen des Verbundes auf Umgebungstemperatur,
wobei der thermische Ausdehnungskoeffizient vom Substrat und/oder Superstrat (1) größer als der thermische Ausdehnungskoeffizient der Solarzelle (3) ist, so dass die Solarzelle (3) dauerhaft für die Lebensdauer des Solarzellenmoduls in einem Temperaturbereich unterhalb 100 °C unter einem vom Substrat und/oder Superstrat (1) ausgehenden und über die Fixierung (2) auf die Solarzelle (3) übertragendem tangentialem Druck steht,
**dadurch gekennzeichnet,**
**dass** als Substrat und/oder Superstrat (1) Glasmaterialien mit einem linearen Wärmeausdehnungskoeffizienten α von mindestens 5·10⁻⁶/K bei 20 °C eingesetzt werden und das mindestens eine Precursormaterial ausgewählt ist aus der Gruppe bestehend aus bei der Verarbeitungstemperatur durch Vernetzung aushärtbaren organischen Materialien und/oder glasartigen anorganischen Materialien, wobei die aushärtbaren organischen Materialien ausgewählt sind aus der Gruppe bestehend aus Monomeren, Oligomeren und/oder Präpolymeren von Duroplasten.

2. Verfahren nach Anspruch 1, **dadurch gekennzeichnet, dass** das mindestens eine Precursormaterial Glaslot ist.

3. Verfahren nach Anspruch 1, **dadurch gekennzeichnet, dass** die aushärtbaren organischen Materialien ausgewählt sind aus Epoxidharzen, Phenol-Harzen, (Meth)acrylatharzen und/oder Polyurethanharzen.

4. Verfahren nach einem der vorhergehenden Ansprüche, **dadurch gekennzeichnet, dass** als Substrat und/oder Superstrat (1) Glasmaterialien mit einem linearen Wärmeausdehnungskoeffizienten α von mindestens mindestens 6·10⁻⁶/K bei 20 °C, bevorzugt mindestens 7·10⁻⁶/K bei 20 °C eingesetzt werden.

5. Verfahren nach einem der vorhergehenden Ansprüche, **dadurch gekennzeichnet, dass** als Solarzelle (3) eine scheibenförmige Solarzelle (3) eingesetzt wird.

6. Verfahren nach einem der vorhergehenden Ansprüche, **dadurch gekennzeichnet, dass** die Dicke der Solarzelle (3) < 500 µm, bevorzugt < 300 µm, besonders bevorzugt < 150 µm beträgt.

7. Verfahren nach einem der vorhergehenden Ansprüche, **dadurch gekennzeichnet, dass** das die Fixierung (2) bildende mindestens eine Precursormaterial in einer Dicke von 5 bis 500 µm, bevorzugt von 10 bis 100 µm, besonders bevorzugt von 20 bis 50 µm aufbracht wird.

8. Verfahren nach einem der vorhergehenden Ansprüche, **dadurch gekennzeichnet, dass** die Verarbeitungstemperatur von 100 bis 600 °C, bevorzugt von 100 bis 300 °C, besonders bevorzugt von 150 bis 250 °C beträgt.

9. Solarzellenmodul herstellbar nach einem Verfahren nach einem der Ansprüche 1 bis 8, umfassend mindestens eine über eine Fixierung (2) zumindest bereichsweise kraft- und formschlüssig mit mindestens ei-nem Substrat und/oder Superstrat (1), ausgewählt aus der Gruppe bestehend aus Glasmaterialien mit einem linearen Wärmeausdehnungskoeffizienten α von mindestens 5·10⁻⁶/K bei 20 °C verbundene Solarzelle (3), **dadurch gekennzeichnet, dass** der thermische Ausdehnungskoeffizient vom Substrat und/oder Superstrat (1) größer als der thermische Ausdehnungskoeffizient der Solarzelle (3) ist und die Solarzelle (3) in einem Temperaturbereich unterhalb 100 °C unter einem vom Substrat und/oder Superstrat (1) ausgehenden und über die Fixierung (2) auf die Solarzelle (3) übertragenen tangentialem Druck steht.

10. Solarzellenmodul nach vorhergehendem Anspruch, **dadurch gekennzeichnet, dass** die Fixierung (2) eine Schichtdicke von 5 bis 500 µm, bevorzugt von 10 bis 100 µm, besonders bevorzugt von 20 bis 50 µm aufweist.

11. Solarzellenmodul nach einem der Ansprüche 9 bis 10, **gekennzeichnet durch** eine rückseitig auf die Solarzelle (3) und/oder das Superstrat (1) aufgebrachte Verkapselung, auf der eine Rückseitenfolie, eine Glasplatte und/oder eine Metalischicht oder-fofie oder-platte, bevorzugt eine Rückseitenfolie aus einem Fluorpolymer angeordnet ist.

12. Solarzellenmodul nach einem der Ansprüche 9 bis 10, **gekennzeichnet durch** eine rückseitig auf die Solarzelle (3) und/oder das Superstrat (1) aufgebrachte Rückseitenfolie, eine Glasplatte und/oder eine Metallschicht, -folie oder-platte, die lediglich im Randbereich über eine umlaufende Abdichtung mit der Solarzelle (3) und/oder dem Superstrat (1) verbunden ist.

## Claims

1. Method for the production of a solar cell module having the following steps:
a) applying a precursor material at least in regions on at least one of the contact faces of a solar cell (3), a surface of a substrate and/or of a superstrate (1),
b) joining the contact faces together,
c) heating the substrate, the superstrate (1), the solar cell (3) and/or the precursor material to a processing temperature of at least 100°C, the steps a), b) and c) also being able to be carried out in any sequence,
d) curing the precursor material in order to fix (2) the solar cell (3) to the substrate and/or the superstrate, and
e) cooling the composite to ambient temperature,
the thermal coefficient of expansion of the substrate and/or superstrate (1) being greater than the thermal coefficient of expansion of the solar cell (3), so that the solar cell (3) is under a tangential pressure permanently for the lifespan of the solar cell module, which pressure emanates from the substrate and/or superstrate (1) and is transmitted via the fixing (2) to the solar cell (3) in a temperature range below 100°C,
**characterised**
**in that** there are used as substrate and/or superstrate (1) glass materials with a linear coefficient of thermal expansion α of at least 5·10⁻⁶/K at 20°C and the at least one precursor material is selected from the group consisting of organic materials which can be cured by cross-linking at the processing temperature and/or glass-like inorganic materials, the curable organic materials being selected from the group consisting of monomers, oligomers and/or prepolymers of thermosets.

2. Method according to claim 1, **characterised in that** the at least one precursor material is glass solder.

3. Method according to claim 1, **characterised in that** the curable organic materials are selected from epoxy resins, phenol resins, (meth)acrylate resins and/or polyurethane resins.

4. Method according to one of the preceding claims, **characterised in that** there are used as substrate and/or superstrate (1) glass materials with a linear coefficient of thermal expansion α of at least 6·10⁻⁶/K at 20°C, preferably at least 7·10⁻⁶/K at 20°C.

5. Method according to one of the preceding claims, **characterised in that** a disc-shaped solar cell (3) is used as the solar cell (3).

6. Method according to one of the preceding claims, **characterised in that** the thickness of the solar cell (3) is < 500 µm, preferably < 300 µm, particularly preferably < 150 µm.

7. Method according to one of the preceding claims, **characterised in that** the at least one precursor material forming the fixing (2) is applied in a thickness of 5 to 500 µm, preferably of 10 to 100 µm, particularly preferably of 20 to 50 µm.

8. Method according to one of the preceding claims, **characterised in that** the processing temperature is from 100 to 600°C, preferably from 100 to 300°C, particularly preferably from 150 to 250°C.

9. Solar cell module producible according to a method according to one of claims 1 to 8, comprising at least one solar cell (3) which is connected via a fixing (2) at least in regions in a force- and form-fit to at least one substrate and/or superstrate (1) selected from the group consisting of glass materials with a linear coefficient of thermal expansion α of at least 5·10⁻⁶/K at 20°C, **characterised in that** the thermal coefficient of expansion of the substrate and/or superstrate (1) is greater than the thermal coefficient of expansion of the solar cell (3) and the solar cell (3) is under a tangential pressure which emanates from the substrate and/or superstrate (1) and is transmitted via the fixing (2) to the solar cell (3) in a temperature range below 100°C.

10. Solar cell module according to the preceding claim, **characterised in that** the fixing (2) has a layer thickness of 5 to 500 µm, preferably of 10 to 100 µm, particularly preferably of 20 to 50 µm.

11. Solar cell module according to one of claims 9 to 10, **characterised by** an encapsulation which is applied on the solar cell (3) and/or the superstrate (1) on the rear side, on which encapsulation a rear-side foil, a glass plate and/or a metal layer or metal foil or metal plate, preferably a rear-side foil made of a fluoropolymer, is disposed.

12. Solar cell module according to one of claims 9 to 10, **characterised by** a rear-side foil which is applied on the solar cell (3) and/or the superstrate (1) on the rear side, a glass plate and/or a metal layer, metal foil or metal plate which is connected to the solar cell (3) and/or the superstrate (1) merely in the edge region via a circumferential seal.

## Revendications

1. Procédé de fabrication d'un module à cellule photovoltaïque avec les étapes suivantes :
a) application, au moins sur certaines zones, d'un matériau précurseur sur au moins une des surfaces de contact d'une cellule photovoltaïque (3), une surface d'un substrat et/ou d'un superstrat (1),
b) assemblage des surfaces de contact,
c) chauffage du substrat, du superstrat (1), de la cellule photovoltaïque (3) et/ou du matériau précurseur à une température de traitement d'au moins 100°C, les étapes a), b) et c) peuvent également être effectuées dans un ordre quelconque,
d) durcissement du matériau précurseur pour la fixation (2) de la cellule photovoltaïque (3) avec le substrat et/ou le superstrat, ainsi que
e) refroidissement du composite à la température ambiante,
le coefficient de dilatation thermique du substrat et/ou du superstrat (1) étant supérieur au coefficient de dilatation thermique de la cellule photovoltaïque (3), de façon à ce que la cellule photovoltaïque (3) soit soumise en permanence, pendant la durée de vie du module à cellule photovoltaïque, dans une plage de température inférieure à 100°C, à une pression tangentielle, sortant du substrat et/ou du superstrat (1), et se transmettant par l'intermédiaire de la fixation (2) vers la cellule photovoltaïque (3),
**caractérisé en ce que**
des matériaux de type verres avec un coefficient de dilatation thermique linéaire α d'au moins 5.10⁻⁶/K à 20°C sont utilisés comme substrat et/ou superstrat (1) et l'au moins un matériau précurseur est sélectionné dans le groupe constitué de matériaux organiques durcissant à la température de traitement par réticulation et/ou de matériaux anorganiques vitreux, les matériaux organiques durcissables étant sélectionnés dans le groupe constitué de monomères, d'oligomères et/ou de pré-polymères de duroplasts.

2. Procédé selon la revendication 1, **caractérisé en ce que** l'au moins un matériau précurseur est une soudure de verre.

3. Procédé selon la revendication 1, **caractérisé en ce que** les matériaux organiques durcissables sont sélectionnés parmi des résines époxy, des résines phénoliques, des résines (méth)acrylates et/ou des résines polyuréthanes.

4. Procédé selon l'une des revendications précédentes, **caractérisé en ce que** des matériaux de types verres avec un coefficient de dilatation thermique linéaire α d'au moins 6.10⁻⁶/K à 20°C, de préférence d'au moins 7.10⁻⁶/K à 20°C sont utilisés comme substrat et/ou superstrat (1).

5. Procédé selon l'une des revendications précédentes, **caractérisé en ce qu'**une cellule photovoltaïque en forme de disque (3) est utilisée en tant que cellule photovoltaïque (3).

6. Procédé selon l'une des revendications précédentes, **caractérisé en ce que** l'épaisseur de la cellule photovoltaïque (3) est < 500 µm, de préférence < 300 µm, de préférence < 150 µm.

7. Procédé selon l'une des revendications précédentes, **caractérisé en ce que** l'au moins un matériau précurseur formant la fixation (2) est appliqué sur une épaisseur de 5 à 500 µm, de préférence de 10 à 100 µm, de préférence de 20 à 50 µm.

8. Procédé selon l'une des revendications précédentes, **caractérisé en ce que** la température de traitement est de 100 à 600°C, de préférence de 100 à 300°C, de préférence de 150 à 250°C.

9. Module à cellule photovoltaïque selon un procédé selon l'une des revendications 1 à 8, comprenant au moins une cellule photovoltaïque (3) reliée, au moins sur certaines zones par friction et par complémentarité de forme, par l'intermédiaire d'une fixation (2), avec au moins un substrat et/ou superstrat (1) sélectionné dans le groupe constitué de matériaux vitreux avec un coefficient de dilatation thermique linéaire α d'au moins 5.10⁻⁶/K à 20°C, **caractérisé en ce que** le coefficient de dilatation thermique du substrat et/ou du superstrat (1) est supérieur au coefficient de dilatation thermique de la cellule photovoltaïque (3) et la cellule photovoltaïque (3) est soumise, dans une plage de température inférieure à 100°C, à une pression tangentielle, sortant du substrat et/ou du superstrat (1), et se transmettant par l'intermédiaire de la fixation (2) vers la cellule photovoltaïque (3),

10. Module à cellule photovoltaïque selon la revendication précédente, **caractérisé en ce que** la fixation (2) présente une épaisseur de couche de 5 à 500 µm, de préférence de 10 à 100 µm, de préférence de 20 à 50 µm.

11. Module à cellule photovoltaïque selon l'une des revendication 9 à 10, **caractérisé par** une encapsulation appliquée à l'arrière de la cellule photovoltaïque (3) et/ou du superstrat (1), sur laquelle est disposé un film arrière, une plaque de verre et/ou une couche ou un film ou une plaque métallique, de préférence un film arrière constitué d'un polymère fluoré.

12. Module à cellule photovoltaïque selon l'une des revendication 9 à 10, **caractérisé par** un film arrière une plaque de verre et/ou une couche, un film ou une plaque métallique, appliqué à l'arrière de la cellule photovoltaïque (3) et/ou du superstrat (1), qui est relié à la cellule photovoltaïque (3) et/ou au superstrat (1) uniquement sur le bord par l'intermédiaire d'un joint d'étanchéité circulaire.
